# EUROPEAN PATENT SPECIFICATION

(11) **EP 1 178 872 B1**
(45) Date of publication and mention of the grant of the patent: **08.10.2003**
(21) Application number: 00930746.3
(22) Date of filing: 15.05.2000
(51) Int. Cl.: B24B 37/04, B24B 21/04, B24D 11/04, B24D 11/00

(54) **CHEMICAL MECHANICAL PLANARIZATION OR POLISHING PAD WITH SECTIONS HAVING VARIED GROOVE PATTERNS**
POLIERKISSEN MIT RILLENMUSTER ZUR VERWENDUNG IN EINER CHEMISCH-MECHANISCHEN POLIERVORRICHTUNG
TAMPON D'APLANISSEMENT OU DE POLISSAGE CHIMIQUE MECANIQUE DOTE DE PARTIES PRESENTANT DES MOTIFS A RAINURES VARIES

(30) Priority: 21.05.1999 US 316166
(43) Date of publication of application: 13.02.2002
(60) Divisional application: 03075541.7
(73) Proprietor: LAM RESEARCH CORPORATION, Fremont, CA 94538-6470 (US)
(72) Inventor: JENSEN, Alan, J., Troutdale, OR 97060 (US); THORNTON, Brian, S., Santa Clara, CA 95054 (US)
(74) Representative: Bucks, Teresa Anne
(86) International application number: PCT/US00/13328
(87) International publication number: WO 00/071297

(56) References cited:
- EP-A- 0 878 270
- WO-A-99/06182
- PATENT ABSTRACTS OF JAPAN vol. 018, no. 272 (M-1610), 24 May 1994 (1994-05-24) -& JP 06 047678 A (KAWASAKI STEEL CORP;OTHERS: 03), 22 February 1994 (1994-02-22)

## Description

### FIELD OF THE INVENTION

The present invention relates to a polishing member and pad as per the preamble of claims 1 and 8 respectively. An example of such a member and pad are disclosed by JP 06 047 678 A.

### BACKGROUND OF THE INVENTION

Semiconductor wafers are typically fabricated with multiple copies of a desired integrated circuit design that will later be separated and made into individual chips. A common technique for forming the circuitry on a semiconductor is photolithography. Part of the photolithography process requires that a special camera focus on the wafer to project an image of the circuit on the wafer. The ability of the camera to focus on the surface of the wafer is often adversely affected by inconsistencies or unevenness in the wafer surface. This sensitivity is accentuated with the current drive toward smaller, more highly integrated circuit designs. Semiconductor wafers are also commonly constructed in layers, where a portion of a circuit is created on a first level and conductive vias are made to connect up to the next level of the circuit. After each layer of the circuit is etched on the wafer, an oxide layer is put down allowing the vias to pass through but covering the rest of the previous circuit level. Each layer of the circuit can create or add unevenness to the wafer that is preferably smoothed out before generating the next circuit layer.

Chemical mechanical planarization (CMP) techniques are used to planarize the raw wafer and each layer of material added thereafter. Available CMP systems, commonly called wafer polishers, often use a rotating wafer holder that brings the wafer into contact with a polishing pad moving in the plane of the wafer surface to be planarized. A polishing fluid, such as a chemical polishing agent or slurry containing microabrasives, is applied to the polishing pad to polish the wafer. The wafer holder then presses the wafer against the rotating polishing pad and is rotated to polish and planarize the wafer. 13

The type of polishing pad used on the wafer polisher can greatly affect the removal rate profile across a semiconductor wafer. Ideally, a semiconductor wafer processed in a wafer polisher will see a constant removal rate across the entire wafer surface. Many polishing pads have been designed with one particular pattern of channels or voids to attempt to achieve a desired removal rate. It is known from JP06047678A to have a polishing member for use in chemical mechanical planarization of a semiconductor wafer which comprises a linear belt, which belt is movable in a linear path.

These existing polishing pads often have a signature removal rate pattern that, for example, may remove material from the edge of a semiconductor wafer faster than the inner portion of the wafer. Accordingly, there is a need for a polishing pad that will enhance uniformity across the surface of a semiconductor wafer.

### SUMMARY OF THE INVENTION

According to a first aspect of the present invention, a polishing member is provided having the features of claim 1.

According to a second aspect of the present invention, a polishing pad for chemical mechanical planarization of semiconductor wafers is provided having the features of claim 8.

According to another aspect of the present invention, a method of producing a linear chemical mechanical planarization polishing pad having a plurality of polishing pad sections is provided having the features of claim 20. Such a method relates to a manufacturing process of the polishing pad of claim 8.

### BRIEF DESCRIPTION OF THE DRAWINGS

FIG. 1 is a perspective view of a polishing member having a polishing pad according to a preferred embodiment of the present invention.
FIG. 2 is a partial plan view of an alternative embodiment of the polishing pad of FIG. 1.
FIG. 3 is a cross-sectional view of a grooved polishing pad section suitable for use in the polishing pad of FIGS. 1 or 2.
FIG. 4 is a partial plan view of a second alternative embodiment of the polishing pad of FIG. 1.
FIG. 5 is a plan view of a rotary polishing pad according to a preferred embodiment.
FIG. 6 is a graphical representation of material removal rate measurements made according to a preferred embodiment of the method of the present invention.
FIG. 7 is a graphical representation of the material removal rates obtained by combining selected polishing pad sections described in FIG. 4 according to a preferred embodiment.

### DETAILED DESCRIPTION OF THE PRESENTLY PREFERRED EMBODIMENTS

One important factor in a chemical mechanical planarization (CMP) process is the uniformity of the resulting polish across the surface of a semiconductor wafer. By leaving uniform material thickness at all points on the wafer after completion of the polishing process, an integrated circuit die on the wafer will be more likely to maintain the same performance characteristics independent of where it originated on the wafer. As set forth below, a CMP polishing pad according to an embodiment of the present invention provides improved uniformity in removal rates and can lead to improved manufacturing process control and increased wafer yield.

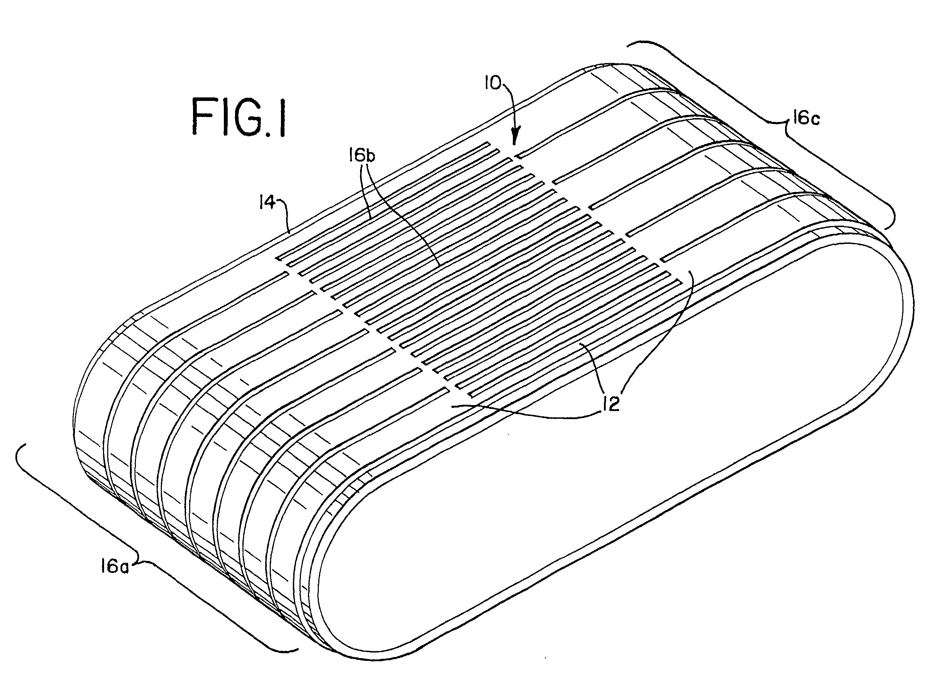

FIG. 1 illustrates a presently preferred embodiment of a CMP polishing pad 10 according to the present invention. The polishing pad 10 includes a plurality of polishing pad sections 12. Each polishing pad section 12 is positioned adjacent to the next so that the sections form an unbroken, serially linked chain on the supporting linear belt 14. Each polishing pad section is formed with its own respective groove pattern 16a-c. Also, each groove pattern 16a-c is arranged parallel to the direction of motion of the linear belt 14. Each pad section 12 may be constructed from a separate piece of pad material and connected together to form the complete polishing pad 10. Alternatively, the polishing pad sections 12 may be manufactured in a single piece of material. The polishing pad sections may either be mounted on a separate belt, as shown in FIG. 1, or may form a polishing pad that is a stand-alone belt

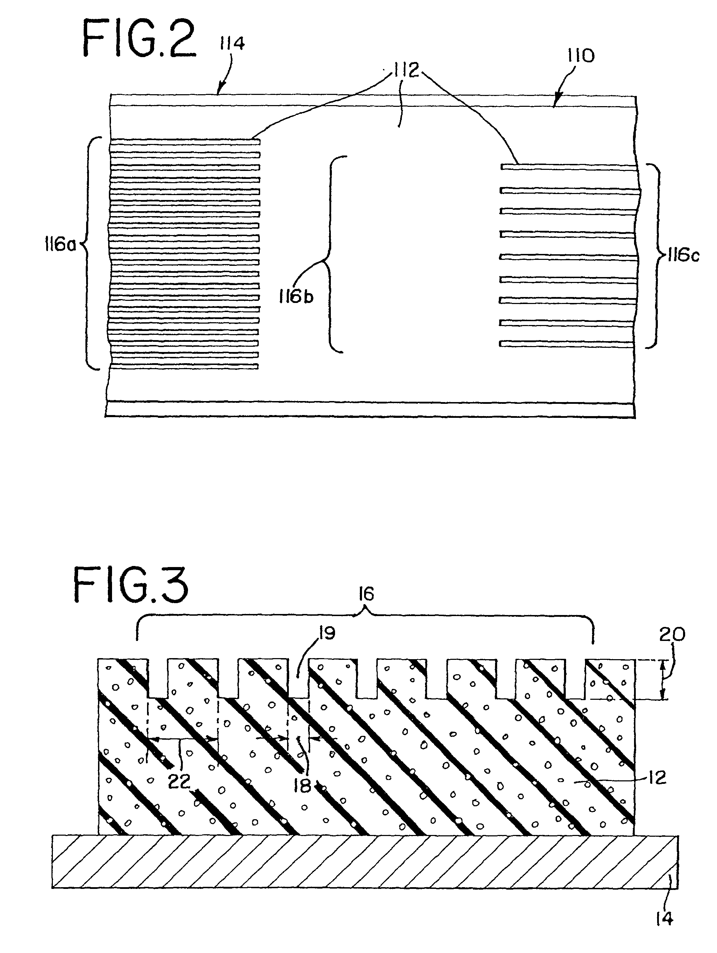

Referring to FIG. 2, an alternative embodiment is shown where the polishing pad 110 includes sections 112 having groove patterns 116a, 116c and a section completely lacking grooves (i.e. an unbroken polishing pad surface) 116b. Again, the grooves are arranged parallel to the direction of motion of the linear belt 114. Each groove pattern, in-one preferred embodiment, is defined by a width, a depth, and a pitch.

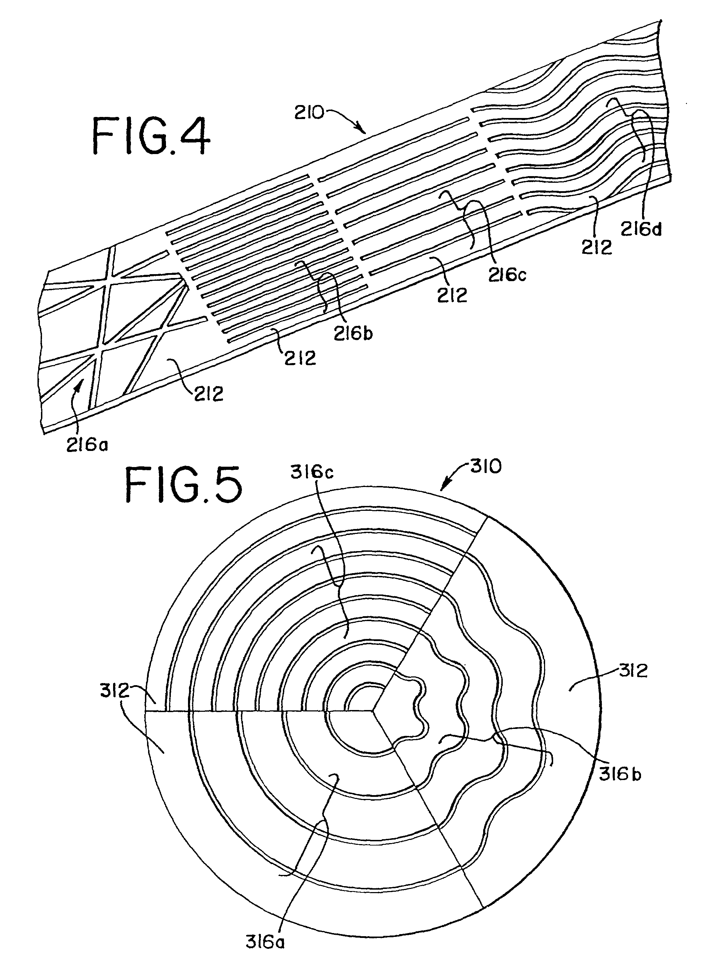

As illustrated in FIG. 3, the width 18 of a groove 19 is the distance between opposing parallel walls of the groove. The depth 20 is the distance from the outer surface of the polishing pad to the bottom of the groove, and the pitch 22 is the distance from a first wall of a first groove to a respective first wall of the immediately adjacent groove. In the embodiments of FIGS. 1 -3, the groove pattern differs between pad sections but is preferably uniform within a given pad section 12, 112 so that the width, depth and pitch are the same for grooves within a particular pad section. In other embodiments, the groove pattern within a particular pad section may include a width, depth, and pitch that varies between grooves in that pad section. Additionally, while the grooves are preferably formed having a rectilinear cross-section, the grooves may be formed having slanted or curved walls. For purposes of this specification, a groove is defined as a channel that is cut or formed in the pad material where the length of the channel is greater than its width. A groove may or may not extend the entire length of a pad section.

In other embodiments of linear semiconductor polishing or planarization pads, the grooves in a particular pad section may be non-parallel. Referring to the embodiment of FIG. 4, a linear polishing pad 210 is shown including a polishing pad section 212 with a non-parallel groove pattern 216a. The non-parallel groove pattern 216a may have grooves that intersect. The polishing pad section 212 with the non-parallel groove pattern 216a may be combined with other polishing pad sections 212 having parallel groove patterns 216b - 216d. Other combinations, such as a polishing pad with all pad sections having a different, non-parallel groove pattern or a polishing pad with some pad sections having non-parallel grooves and other pad sections having non-grooved surfaces, are contemplated. As shown in the embodiment of FIG. 4, the parallel groove pattern may include pattern of serpentine grooves 216d or other curves that are disposed in either a parallel or a non-parallel relationship to each other. One or more polishing pad sections may have an embossed pattern of circular voids or dimples formed in the pad material, rather than grooves, in yet another embodiment.

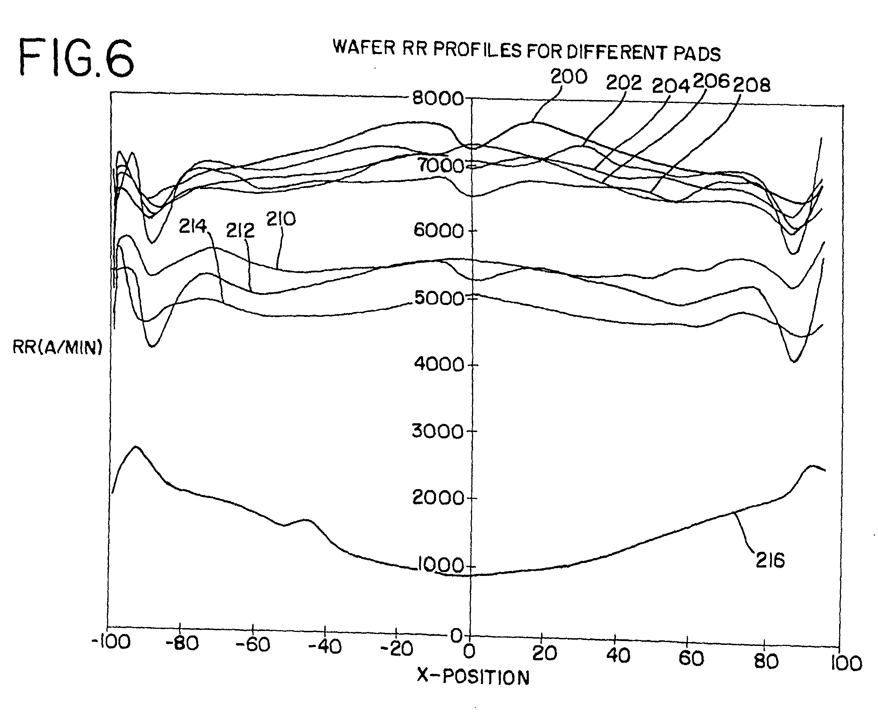

According to another embodiment, the semiconductor polishing pad may be a rotary polishing pad. FIG. 5 illustrates one rotary polishing pad 310 having a plurality of wedge-shaped sections 312 that are serially linked such that a semiconductor wafer is sequentially presented with a different section as the rotary polishing pad is rotated. Each section 312 preferably has a different groove pattern 316a - 316c. In one embodiment, one or more sections 312 may each have a groove pattern that includes a plurality of concentric arc segments (see groove patterns 316a and 316c) centered about the center of the rotary pad. In other embodiments, one or more sections 312 may have a groove pattern including a plurality of non-concentric groove patterns.

One suitable pad material for use in constructing the polishing pad sections that make up the linear or rotary semiconductor polishing pad is a closed cell polyurethane such as 1C1000 available from Rodel Corporation of Phoenix, Arizona. Although each pad section is preferably constructed of the same pad material, in other embodiments, one or more different pad materials may be used for each polishing pad section in the polishing pad. The pad materials may also be selected to have a different hardnesses or densities. In one preferred embodiment, the pad materials may have a Durometer hardness in the range of 50 - 70, a compressibility in the range of 4% - 16%, and a specific gravity in the range of 0.74 - 0.85. The grooves may be fabricated in the pad material using standard techniques used by any of a number of commercial semiconductor wafer polishing pad manufacturers such as Rodel Corp.

Referring to FIGS. 1, 2 and 4, the polishing pad 10, 110, 210 may be mounted to a linear belt 14, 114 in one embodiment and utilized in a linear semiconductor wafer polisher such as the TERES ^{TM} polisher available from Lam Research Corporation of Fremont, California. In operation, the pad 10, 110, 210 is continuously moved along a linear direction while a semiconductor wafer holder (not shown) presses a semiconductor wafer against the surface of the pad. The semiconductor wafer holder may also rotate the wafer while holding the wafer against the pad.

The pad 10, 110,210, along with a slurry that is both chemically active and abrasive to the wafer surface, is used to polish layers on the wafer. Any of a number of known polishing slurries may be used. One suitable slurry is SS25 available from Cabot Corp. The groove pattern 16, 116,216 including the absence grooves, on a pad section changes the ability of the pad to transport slurry underneath the wafer and therefore the groove pattern can affect the material removal rate profile as measured on a cross section of a wafer.

One preferred method for creating a linear CMP polishing pad having a substantially uniform material removal rate profile for a semiconductor wafer is described below. First, several polishing pads, each having a single groove pattern and each completely covering the circumference of a different belt, are each used to polish a semiconductor wafer for a predetermined time. The same wafer polisher, preferably the TERES ^{TM} polisher available from Lam Research Corporation, is used to test each of the polishing pads. After polishing a semiconductor wafer with a particular polishing pad, the amount of material removed is measured at various points across the diameter of the wafer and recorded in a database on a computer. The removal rates are then compared at the respective measurement points used for each semiconductor wafer. Using the comparison data, a determination is made as to what combination of groove patterns, and what length of each particular groove pattern, is predicted to produce a uniform material removal rate across an entire semiconductor wafer. In one preferred embodiment, the comparison of the material removal rates and determination of the appropriate combination of groove patterns may be accomplished using a personal computer running a program written in Excel by Microsoft Corporation.

After calculating the predicted polishing pad sections that produce a polishing pad having a substantially uniform material removal rate across an entire wafer, a polishing pad is fabricated using commonly known fabrication techniques so that the appropriate section lengths for each chosen groove pattern are combined on a single belt. In one embodiment, where a single pad material is used, the pad may be a single, continuous strip having the appropriate groove patterns and lengths formed in it. In another embodiment, separate pieces of pad material, each having its own groove pattern, may be linked together on a single belt

A graphical representation of material removal rates for various groove patterns is illustrated in FIG. 6. The x-axis of the graph in FIG. 6 represents the measurement point along the diameter of the semiconductor wafer in millimeters from the center of the wafer. The y-axis represents the measured removal rate in angstroms per minute. Each trace on the graph represents the measured removal rate for a pad having a particular grove pattern. The downforce (pressure applied to the semiconductor against the pad) for all measurements was 5 pounds per square inch, while the linear speed of the pad and the rotational speed of the wafer holder were 400 feet per minute and 20 revolutions per minute, respectively. Beginning with the uppermost trace in FIG. 6, the groove patterns corresponding to the illustrated material removal rates are as follows:

| Reference Number | Groove Pattern (width x depth x pitch) (all in thousandths of an inch) |
|---|---|
| 200 | K-Groove ^{TM} |
| 202 | 10 x 20 x 40 |
| 204 | 10 x 20 x 100 |
| 206 | 20 x 20 x 50 |
| 208 | 10 x 10 x 100 |
| 210 | 20 x 20 x 40 |
| 212 | 10 x 20 x 50 |
| 214 | 20 x 20 x 100 |
| 216 | No Grooves In Pad |

As is apparent from the example of FIG. 6, the material removal rate and the removal rate profile vary significantly between the different groove patterns. By selecting several groove patterns and calculating a weighted average of removal rates at each point along the diameter of the wafer, where the weighting is based on the percentage of length of the complete pad that will be constructed from a pad section having the particular groove pattern, a predicted removal rate profile may be calculated. In a preferred embodiment, the grooves are oriented parallel to the direction of motion of the pad on the linear belt. While various other groove dimensions are contemplated, the groove dimensions are preferably within the range of 0-30 thousandths of an inch (mils) wide, 5-30 mils deep, and have a pitch in the range of 25-200 mils. The K-Groove ^{TM} trace 200 refers to a commercially available groove pattern from Rodel Corp.

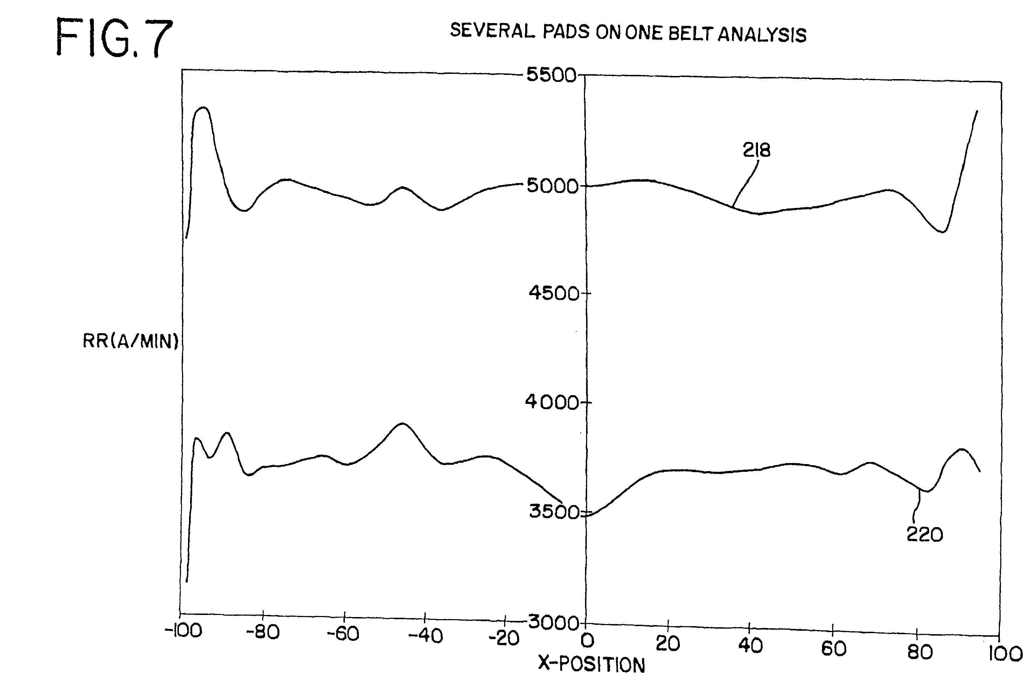

FIG. 7 illustrates a predicted removal rate profile 218 and the actual removal rate profile 220 measured from a polishing pad fabricated according to the method described above. The polishing pad used to generate the removal rate profiles 218, 220 included three polishing pad sections having equal lengths and constructed out of the same polishing pad material. The first polishing pad section included a groove pattern of 0.010" x 0.020" x 0.100" (depth x width x pitch), the second polishing section included a groove pattern of 0.020" x 0.020" x 0.050", and the third polishing pad section had no grooves. Another polishing pad, fabricated according to a preferred embodiment of the present invention, having improved material removal rate uniformity along the entire width of the wafer, is made up of five polishing pad sections: no groove, 12 x 20 x 50, 20 x 20 x 50, 10 x 20 x 100, and 20 x 20 x 100 (where the dimensions are in thousandths of an inch and refer to width x depth x pitch).

From the foregoing, a polishing pad and a method of making the same have been described. The method takes advantage of the different material removal rate profiles of different groove patterns and optimizes a combination of the available groove patterns to form a composite pad having at least two polishing pad sections with different groove patterns. The method provides for comparing removal rate profiles for different groove patterns and mathematically optimizing a resulting combination of polishing pad sections on a single platform to improve the removal rate profile. The resulting pad preferably has a more uniform material removal rate across a semiconductor wafer.

A CMP polishing pad is also disclosed having a plurality of serially linked polishing pad sections. The plurality of pad sections may form a linear belt or may be mounted on a separate linear belt. Also, the pad sections may form a rotary polishing pad. Each polishing pad section includes a different groove pattern that, in a first embodiment, is made up of grooves oriented parallel to the direction of travel of the pad and, in another embodiment, may include grooves that are not parallel to the direction of travel.

It is intended that the foregoing detailed description be regarded as illustrative rather than limiting, and that it be understood that the following claims are intended to define the scope of this invention.

## Claims

1. A polishing member (110) for use in chemical mechanical planarization of semiconductor wafers, the polishing member (110) comprising:
a linear belt (114), the linear belt (114) movable in a linear path; and **characterized by** the polishing member further comprising at least two serially linked polishing pad sections (112) attached to the belt, the polishing pad sections (112) comprising:
a first polishing pad section (112) having a first groove pattern (116a) formed in a side of the first polishing pad section (112) opposite the linear belt (114), wherein the first groove pattern (116a) comprises a plurality of grooves; and
a second polishing pad section (112) having a non-grooved side (116b) opposite the linear belt (114).

2. The polishing member (110) of claim 1, wherein the plurality of grooves are oriented parallel to the linear path of the linear belt (114).

3. The polishing member (110 ) of claim 1, wherein the at least two polishing pad sections (112) further comprise a third polishing pad section (112) having a third groove pattern, the third groove pattern (116c) having a plurality of grooves oriented parallel to the linear path of the linear belt (114), and wherein the third groove pattern (116c) differs from the first groove pattern.

4. The polishing member (110) of claim 3, wherein the at least two polishing pad sections (112) comprise at least two different levels of hardness.

5. The polishing member (110) of claim 3, wherein each of the at least two polishing pad sections (112) comprise at least two different densities.

6. The polishing member (110) of claim 1, wherein the at least two polishing pad sections (112) comprise at least two different material removal profiles, and wherein the serially linked polishing pad sections (112) are configured to produce a polishing member (110) having a substantially uniform material removal profile.

7. The polishing member (110) of claim 6, wherein each of the first plurality of grooves comprises:
a rectangular cross-section having a depth (20) defined by a distance from the surface of the first polishing pad section, a width (18) defined by a distance perpendicular to the depth measured from a first groove wall to a second groove wall, and a pitch spacing (22) defined by a distance between the first groove wall of a first groove in the first plurality of grooves and a respective first wall of a groove immediately adjacent to the first groove.

8. A polishing pad for use in chemical mechanical planarization of semiconductor wafers, the polishing pad **characterized by**,
a plurality of serially linked polishing pad sections (12) forming a linear belt (14) movable in a linear path, the plurality of serially linked polishing pad sections (12) comprising:
a first polishing pad section (12) having a first groove pattern (16a) formed in a surface of the first polishing pad section; and
a second polishing pad section (12) having a second groove pattern (16b) formed in a surface of the second polishing pad section, wherein the second groove pattern (16b) is different than the first groove pattern (16a).

9. The polishing pad of claim 8, wherein the first groove pattern (16a) comprises a first plurality of grooves oriented parallel to the linear path of the linear belt (14).

10. The polishing pad of claim 9, wherein the second groove pattern (16b) comprises a second plurality of grooves and the second plurality of grooves are oriented parallel to the linear path of the linear belt (14).

11. The polishing pad (10) of claim 8, wherein plurality of polishing pad sections (12) further comprises a third polishing pad section (12) having a third groove pattern (16c) having a plurality of grooves oriented parallel to the linear path of the linear belt (14), and wherein the third groove pattern (16c) differs from the first (16a) and second groove patterns (16b).

12. The polishing pad (10) of claim 8, wherein the first and second pad sections (12) are **characterized by** different material removal rate profiles, and wherein the serially linked plurality of polishing pad sections (12) are configured to produce a polishing member (10) having a substantially uniform material removal rate profile.

13. The polishing pad (10) of claim 8, wherein each of the first and second polishing pad sections (12) differ in hardness.

14. The polishing pad (10) of claim 8, wherein each of the first and second polishing pad sections (12) differ in density.

15. The polishing pad (10) of claim 8, wherein the first polishing pad section (12) comprises a length equal to a length of the second polishing pad section

16. The polishing pad of claim 8, wherein the first polishing pad section (12) comprises a length different than a length of the second polishing pad section.

17. The polishing pad of claim 8, wherein at least one of a depth, a width, and a pitch of grooves of the first polishing pad section (12) differs from a respective depth, width, and pitch of grooves of the second polishing pad section.

18. The polishing pad of claim 8, wherein a pitch of grooves in the first groove pattern (16a) is uniform across the first polishing pad section (12).

19. The polishing pad of claim 8, wherein a pitch of grooves in the first groove pattern (16a) varies across the first polishing pad section.

20. A method of producing a linear chemical mechanical planarization polishing pad having a plurality of polishing pad sections (12), the method **characterized by**:
measuring a material removal rate profile for each of a plurality of groove patterns used in chemical mechanical planarization polishing pads;
determining a combination of at least two of the plurality of groove patterns based on the measured removal rate profiles of (a) that provide a substantially uniform material removal rate; and
fabricating a polishing pad comprising a plurality of linked polishing pad sections (12), wherein the polishing pad sections (12) comprise a combination of groove patterns determined in (b) to provide a substantially uniform material removal rate profile on the semiconductor wafer.

21. The method of claim 20, wherein the polishing pad is a linear polishing pad and each of the plurality of groove patterns comprises a groove pattern oriented parallel to a linear path of polishing pad.

22. The method of claim 20, wherein the step of measuring the material removal rate profile on the semiconductor wafer comprises, for each of the groove patterns, measuring a difference between a starting thickness and an ending thickness of the semiconductor wafer at a plurality of points along a diameter of the wafer after planarizing the wafer with a polishing pad having a selected one of the plurality of groove patterns.

23. The polishing pad (10) of claim 8, wherein the plurality of polishing pad sections (12) further comprises a third polishing pad section (12)having a third groove pattern having a plurality of grooves oriented in a non-parallel manner with respect to the linear path of the linear belt (14).

## Patentansprüche

1. Polierglied (110) zur Verwendung bei der chemisch-mechanischen Planarisierung von Halbleiter-Wafern, wobei das Polierglied umfasst:
- ein lineares Band (114), wobei das lineare Band in einem linearen Pfad bewegbar ist; und **dadurch kennzeichnet, dass** das Polierglied des Weiteren mindestens zwei hintereinander verbundene Polierkissenabschnitte (112) umfasst, die am Band befestigt sind, wobei die Polierkissenabschnitte (112) umfassen:
- einen ersten Polierkissenabschnitt (112), der ein erstes Rillenmuster (116a) besitzt, das in einer Seite des ersten Polierkissenabschnitts (112) gegenüber dem linearen Band (114) gebildet ist, wobei das erste Rillenmuster (16a) eine Vielzahl von Rillen aufweist; und
- einen zweiten Polierkissenabschnitt (112), der eine nicht gerillte Seite (116b) gegenüber dem linearen Band (114) aufweist.

2. Polierglied (110) nach Anspruch 1, wobei die Vielzahl der Rillen parallel zum linearen Pfad des linearen Bands (114) ausgerichtet ist.

3. Polierglied (110) nach Anspruch 1, wobei die mindestens zwei Polierkissenabschnitte (112) des Weiteren einen dritten Polierkissenabschnitt (112) umfassen, der ein drittes Rillenmuster besitzt, wobei das dritte Rillenmuster (116c) eine Vielzahl von Rillen aufweist, die parallel zum linearen Pfad des linearen Bands (114) ausgerichtet sind, und wobei das dritte Rillenmuster (116c) sich vom ersten Rillenmuster unterscheidet.

4. Polierglied (110) nach Anspruch 3, wobei die mindestens zwei Polierkissenabschnitte (112) mindestens zwei verschiedene Härtegrade aufweisen.

5. Polierglied (110) nach Anspruch 3, wobei jeder der mindestens zwei Polierkissenabschnitte (112) mindestens zwei verschiedene Dichten aufweist.

6. Polierglied (110) nach Anspruch 1, wobei die mindestens zwei Polierkissenabschnitte (112) mindestens zwei verschiedene Materialabtragprofile aufweisen, und wobei die hintereinander verbundenen Polierkissenabschnitte (112) so konfiguriert sind, dass sie ein Polierglied (110) erzeugen, das ein im wesentlichen einheitliches Materialabtragprofil aufweist.

7. Polierglied (110) nach Anspruch 6, wobei jede der ersten Vielzahl von Rillen aufweist:
- einen rechtwinkligen Querschnitt mit einer Tiefe (20), die durch einen Abstand von der Oberfläche des ersten Polierkissenabschnitts definiert ist, eine Breite (18), die durch einen Abstand senkrecht zur Tiefe definiert ist, die von einer ersten Rillenwand zu einer zweiten Rillenwand gemessen wird, und eine Zwischenraumbeabstandung (22), die durch einen Abstand zwischen der ersten Rillenwand einer ersten Rille in der ersten Vielzahl von Rillen und einer entsprechenden ersten Wand einer Rille definiert wird, die direkt an die erste Rille angrenzt.

8. Polierkissen zur Verwendung bei der chemisch-mechanischen Planarisierung von Halbleiter-Wafern, wobei das Polierkissen **gekennzeichnet ist durch**:
- eine Vielzahl hintereinander verbundener Polierkissenabschnitte (12), die ein lineares Band (14) bilden, der in einem linearen Pfad bewegbar ist, wobei die Vielzahl hintereinander verbundener Polierkissenabschnitte (12) aufweist:
- einen ersten Polierkissenabschnitt (12), der ein erstes Rillenmuster (16a) besitzt, das in einer Oberfläche des ersten Polierkissenabschnitts gebildet ist; und
- einen zweiten Polierkissenabschnitt (12), der ein zweites Rillenmuster (16b) besitzt, das in einer Oberfläche des zweiten Polierkissenabschnitts gebildet ist, wobei das zweite Rillenmuster (16b) sich vom ersten Rillenmuster (16a) unterscheidet.

9. Polierkissen nach Anspruch 8, wobei das erste Rillenmuster (16a) eine erste Vielzahl von Rillen umfasst, die parallel zum linearen Pfad des linearen Bands (14) ausgerichtet sind.

10. Polierkissen nach Anspruch 9, wobei das zweite Rillenmuster (16b) eine zweite Vielzahl von Rillen umfasst, und die zweite Vielzahl von Rillen parallel zum linearen Pfad des linearen Bands (14) ausgerichtet ist.

11. Polierkissen (10) nach Anspruch 8, wobei eine Vielzahl von Polierkissenabschnitten (12) des Weiteren einen dritten Polierkissenabschnitt (12) umfasst, der ein drittes Rillenmuster (16c) besitzt, das eine Vielzahl parallel zum linearen Pfad des linearen Bands (14) ausgerichteter Rillen aufweist, und wobei das dritte Rillenmuster (16c) sich vom ersten (16a) und zweiten Rillenmuster (16b) unterscheidet.

12. Polierkissen (10) nach Anspruch 8, wobei der erste und zweite Kissenabschnitt (12) durch unterschiedliche Materialabtragratenprofile gekennzeichnet sind, und wobei die Vielzahl hintereinander verbundener Polierkissenabschnitte (12) so konfiguriert ist, dass sie ein Polierglied (10) erzeugen, das ein im wesentlichen einheitliches Materialabtragratenprofil aufweist.

13. Polierkissen (10) nach Anspruch 8, wobei jeder der ersten und zweiten Polierkissenabschnitte (12) eine unterschiedliche Härte aufweist.

14. Polierkissen (10) nach Anspruch 8, wobei jeder der ersten und zweiten Polierkissenabschnitte (12) eine unterschiedliche Dichte aufweist.

15. Polierkissen (10) nach Anspruch 8, wobei der erste Polierkissenabschnitt (12) eine Länge aufweist, die gleich einer Länge des zweiten Polierkissenabschnitts ist.

16. Polierkissen nach Anspruch 8, wobei der erste Polierkissenabschnitt (12) eine Länge aufweist, die sich von einer Länge des zweiten Polierkissenabschnitts unterscheidet.

17. Polierkissen nach Anspruch 8, wobei sich mindestens eine Tiefe, eine Breite oder ein Rillenzwischenraum des ersten Polierkissenabschnitts (12) von einer entsprechenden Tiefe, einer Breite oder einem Rillenzwischenraum des zweiten Polierkissenabschnitts (12) unterscheidet.

18. Polierkissen nach Anspruch 8, wobei ein Rillenzwischenraum im ersten Rillenmuster (16a) über den ersten Polierkissenabschnitt (12) hinweg einheitlich ist.

19. Polierkissen nach Anspruch 8, wobei ein Rillenzwischenraum im ersten Rillenmuster (16a) über den ersten Polierkissenabschnitt (12) hinweg variiert.

20. Verfahren zur Herstellung eines Polierkissens für lineare chemisch-mechanische Planarisierung mit einer Vielzahl von Polierkissenabschnitten (12), wobei das Verfahren **gekennzeichnet ist durch**:
- die Messung des Materialabtragratenprofils für jedes einer Vielzahl von Rillenmustern, die bei Polierkissen für die chemisch-mechanische Planarisierung verwendet werden;
- die Festlegung einer Kombination von mindestens zwei der Vielzahl von Rillenmustern auf der Grundlage des gemessenen Materialabtragratenprofils aus (a), die eine im wesentlichen einheitliche Materialabtragrate bereitstellt; und
- die Herstellung eines Polierkissens, das eine Vielzahl verbundener Polierkissenabschnitte (12) umfasst, wobei die Polierkissenabschnitte (12) eine Kombination von Rillenmustern umfassen, die in (b) festgelegt wurden, um ein im wesentlichen einheitliches Materialabtragratenprofil auf dem Halbleiter-Wafer bereitzustellen,

21. Verfahren nach Anspruch 20, wobei das Polierkissen ein lineares Polierkissen ist, und jedes der Vielzahl von Rillenmustern ein Rillenmuster umfasst, das parallel zu einem linearen Pfad des Polierkissens ausgerichtet ist.

22. Verfahren nach Anspruch 20, wobei der Schritt zum Messen des Materialabtragratenprofils auf dem Halbleiter-Wafer für jedes Rillenmuster die Messung der Differenz zwischen einer Anfangsdicke und einer Enddicke des Halbleiter-Wafers an einer Vielzahl von Punkten entlang eines Durchmessers des Wafers umfasst, nachdem der Wafer mit einem Polierkissen poliert wurde, das ein ausgewähltes der Vielzahl von Rillenmustern aufweist.

23. Polierkissen (10) nach Anspruch 8, wobei die Vielzahl von Polierkissenabschnitten (12) des Weiteren einen dritten Polierkissenabschnitt (12) umfasst, der ein drittes Rillenmuster mit einer Vielzahl von Rillen aufweist, die bezüglich des linearen Pfads des linearen Bands (14) in einer nichtparallelen Weise ausgerichtet sind.

## Revendications

1. Elément de polissage (110) destiné à être utilisé dans l'arasement mécano-chimique de plaquettes semi-conductrices, l'élément de polissage (110) comportant :
une courroie linéaire (114), la courroie linéaire (114) étant mobile dans un trajet linéaire, et **caractérisé en ce que** 1 ' élément de polissage comporte de plus au moins deux tronçons de tampon de polissage reliés en série (112) fixés sur la courroie, les tronçons de tampon de polissage (112) comportant :
un premier tronçon de tampon de polissage (112) ayant un premier motif de gorges (116a) formé dans le côté du premier tronçon de tampon de polissage (112) opposé à la courroie linéaire (114), le premier motif de gorges (116a) comportant une pluralité de gorges, et
un deuxième tronçon de tampon de polissage (112) ayant un côté non-muni de gorges (116b) opposé à la courroie linéaire (114).

2. Elément de polissage (110) selon la revendication 1, dans lequel la pluralité de gorges est orientée parallèlement au trajet linéaire de la courroie linéaire (114).

3. Elément de polissage (110) selon la revendication 1, dans lequel les au moins deux tronçons de tampon de polissage (112) comportent de plus un troisième tampon de polissage (112) ayant un troisième motif de gorges, le troisième motif de gorges (116c) ayant une pluralité de gorges orientées parallèlement au trajet linéaire de la courroie linéaire (114), et dans lequel le troisième motif de gorges (116e) est différent du premier motif de gorges.

4. Elément de polissage (110) selon la revendication 3, dans lequel les au moins deux tronçons de tampon de polissage (112) comportent au moins deux niveaux de dureté différents.

5. Elément de polissage (110) selon la revendication 3, dans lequel chacun des au moins deux tronçons de tampon de polissage (112) comporte au moins deux densités différentes.

6. Elément de polissage (110) selon la revendication 1, dans lequel les au moins deux tronçons de tampon de polissage (112) comportent au moins deux profils d'enlèvement de matériau différents, et dans lequel les tronçons de tampon de polissage reliés en série (112) sont configurés pour produire un élément de polissage (110) ayant un profil d'enlèvement de matériau sensiblement uniforme.

7. Elément de polissage (110) selon la revendication 6, dans lequel chacune de la première pluralité de gorges comporte :
une section transversale rectangulaire ayant une profondeur (20) définie par la distance à partir de la surface du premier tronçon de tampon de polissage, une largeur (18) définie par la distance, perpendiculairement à la profondeur, mesurée à partir d'une première paroi de gorge jusqu'à une seconde paroi de gorge, et un écartement formant pas (22) défini par la distance entre la première paroi de gorge d'une première gorge de la première pluralité de gorges et une première paroi respective d'une gorge immédiatement adjacente à la première gorge.

8. Tampon de polissage destiné à être utilisé dans un arasement mécano-chimique de plaquettes semi-conductrices, le tampon de polissage étant **caractérisé en ce qu'**il comporte :
une pluralité de tronçons de tampon de polissage reliés en série (12) formant une courroie linéaire (14) mobile dans un trajet linéaire, la pluralité de tronçons de tampon de polissage reliés en série (12) comportant :
un premier tronçon de tampon de polissage (12) ayant un premier motif de gorges (16a) formé dans une surface du premier tronçon de tampon de polissage, et
un deuxième tronçon de tampon de polissage (12) ayant un deuxième motif de gorges (16b) formé dans une surface du deuxième tronçon de tampon de polissage, le deuxième motif de gorges (16b) étant différent du premier motif de gorges (16a).

9. Tampon de polissage selon la revendication 8, dans lequel le premier motif de gorges (16a) comporte une première pluralité de gorges orientées parallèlement au trajet linéaire de la courroie linéaire (14).

10. Tampon de polissage selon la revendication 9, dans lequel le deuxième motif de gorges (16b) comporte une seconde pluralité de gorges et la seconde pluralité de gorges est orientée parallèlement au trajet linéaire de la courroie linéaire (14).

11. Tampon de polissage (10) selon la revendication 8, dans lequel une pluralité de tronçons de tampon de polissage (12) comporte de plus un troisième tronçon de tampon de polissage (12) ayant un troisième motif de gorges (16c) ayant une pluralité de gorges orientées parallèlement au trajet linéaire de la courroie linéaire (14), et dans lequel le troisième motif de gorges (16c) est différent du premier (16a) et du deuxième motif de gorges (16b).

12. Tampon de polissage (10) selon la revendication 8, dans lequel les premier et deuxième tronçons de tampon (12) sont **caractérisés par** des profils de taux d'enlèvement de matériau différents, et dans lequel la pluralité de tronçons de tampon de polissage reliés en série (12) est configurée pour produire un élément de polissage (10) ayant un profil de taux d'enlèvement de matériau sensiblement uniforme.

13. Tampon de polissage (10) selon la revendication 8, dans lequel chacun parmi le premier et le deuxième tronçon de tampon de polissage (12) a une dureté différente.

14. Tampon de polissage (10) selon la revendication 8, dans lequel chacun parmi le premier et le deuxième tronçon de tampon de polissage (12) a une densité différente.

15. Tampon de polissage (10) selon la revendication 8, dans lequel le premier tronçon de tampon de polissage (12) a une longueur égale à la longueur du deuxième tronçon de tampon de polissage.

16. Tampon de polissage selon la revendication 8, dans lequel le premier tronçon de tampon de polissage (12) a une longueur différente de la longueur du deuxième tronçon de tampon de polissage.

17. Tampon de polissage selon la revendication 8, dans lequel au moins un élément parmi la profondeur, la largeur et le pas des gorges du premier tronçon de tampon de polissage (12) est différent de la profondeur, la largeur et le pas respectifs des gorges du deuxième tronçon de tampon de polissage.

18. Tampon de polissage selon la revendication 8, dans lequel le pas des gorges du premier motif de gorges (16a) est uniforme à travers le premier tronçon de tampon de polissage (12) .

19. Tampon de polissage selon la revendication 8, dans lequel le pas des gorges du premier motif de gorges (16a) varie à travers le premier tronçon de tampon de polissage.

20. Procédé de production d'un tampon de polissage pour arasement mécano-chimique linéaire ayant une pluralité de tronçons de tampon de polissage (12), le procédé étant **caractérisé en ce qu'**il comporte les étapes consistant à :
mesurer un profil de taux d'enlèvement de matériau pour chacun d'une pluralité de motifs de gorges utilisés dans des tampons de polissage pour arasement mécano-chimique,
déterminer une combinaison d'au moins deux parmi la pluralité de motifs de gorges sur la base des profils de taux d'enlèvement mesurés à l'étape (a) qui fournit un taux d'enlèvement de matériau sensiblement uniforme, et
fabriquer un tampon de polissage comportant une pluralité de tronçons de tampon de polissage reliés (12), les tronçons de tampon de polissage (12) comportant une combinaison de motifs de gorges déterminée à l'étape (b) pour fournir un profil de taux d'enlèvement de matériau sensiblement uniforme sur la plaquette semi-conductrice.

21. Procédé selon la revendication 20, dans lequel le tampon de polissage est un tampon de polissage linéaire et chacun parmi la pluralité de motifs de gorges comporte un motif de gorges orienté parallèlement à un trajet linéaire de tampon de polissage.

22. Procédé selon la revendication 20, dans lequel l'étape consistant à mesurer le profil de taux d'enlèvement de matériau sur la plaquette semi-conductrice comporte, pour chacun des motifs de gorges, la mesure de la différence entre une épaisseur de départ et une épaisseur de fin de la plaquette semi-conductrice au niveau d'une pluralité de points situés le long d'un diamètre de la plaquette après arasement de la plaquette à l'aide d'un tampon de polissage ayant un motif sélectionné parmi la pluralité de motifs de gorges.

23. Tampon de polissage (10) selon la revendication 8, dans lequel la pluralité de tronçons de tampon de polissage (12) comporte de plus un troisième tronçon de tampon de polissage (12) ayant un troisième motif de gorges ayant une pluralité de gorges orientées d'une manière non-parallèle par rapport au trajet linéaire de la courroie linéaire (14).
